(19) Europäisches Patentamt
European Patent Office
Office européen des brevets

(11) **EP 1 298 792 B1**

(12) **FASCICULE DE BREVET EUROPEEN**

(45) Date de publication et mention
de la délivrance du brevet:
**10.03.2010 Bulletin 2010/10**

(51) Int Cl.:
***H03D 7/16*** *(2006.01)*

(21) Numéro de dépôt: **02078864.2**

(22) Date de dépôt: **18.09.2002**

(54) **Mélangeur utilisant une cellule à Gilbert**

Gilbert-Multiplizierer-Zelle Mischer

Gilbert-Cell Mixer

(84) Etats contractants désignés:
**AT BE BG CH CY CZ DE DK EE ES FI FR GB GR
IE IT LI LU MC NL PT SE SK TR**

(30) Priorité: **28.09.2001 FR 0112509**

(43) Date de publication de la demande:
**02.04.2003 Bulletin 2003/14**

(73) Titulaire: **NXP B.V.
5656 AG Eindhoven (NL)**

(72) Inventeur: **Monge, Laurent,
Societe Civile S.P.I.D.
75008 Paris (FR)**

(74) Mandataire: **Zapalowicz, Francis et al
Casalonga & Partners
Bayerstrasse 71/73
80335 München (DE)**

(56) Documents cités:
**US-A- 5 805 988    US-A- 6 026 286**

- **K. NEGUS: "3.3V GPS RECEIVER MMIC
IMPLEMENTED ON A MIXED SIGNAL SILICON
BIPOLAR ARRAY" 1992 IEEE INTERNATIONAL
MICROWAVE SYMPOSIUM DIGEST, vol. 2, 1 juin
1992 (1992-06-01), pages 1071-1074,
XP000343479 NEW YORK,US**
- **D. BOWERS: "MINIMIZING NOISE IN ANALOG
BIPOLAR CIRCUIT DESIGN" IEEE :
PROCEEDINGS OF THE BIPOLAR CIRCUITS
TECHNOLOGY MEETING, 18 septembre 1989
(1989-09-18), XP010089296 MINNEAPOLIS,US**
- **J. WHOLEY: "SILICON BIPOLAR DOUBLE
BALANCED ACTIVE MIXER MMICS FOR RF AND
MICROWAVE APPLICATIONS UP TO 6 GHZ" 1989
IEEE MTT-S INTERNATIONAL MICROWAVE
SYMPOSIUM DIGEST, vol. 1, 13 juin 1989
(1989-06-13), pages 281-285, XP000077168 NEW
YORK,US**
- **N. ITCH: "THE ANALYSIS OF SILICON BIPOLAR
SCALING SCHEME FOR LOW NOISE AND LOW
POWER ANALOG APPLICATION" 1994
BIPOLAR/BICMOS CIRCUITS AND
TECHNOLOGY MEETING IEEE., 1 janvier 1994
(1994-01-01), pages 60-63, XP010224823 NEW
YORK,US**

**Description**

L'invention concerne un circuit de mélange pour mélanger un premier signal à un second signal. L'invention concerne plus généralement le domaine des circuits analogiques de traitement du signal, en particulier les télécommunications et radiocommunications.

Un circuit de mélange est connu du brevet EP0232560. Le circuit inclut deux transistors reliés à des résistances de charge et à un circuit de conversion d'une puissance en courant, la sortie du circuit de conversion étant reliée aux émetteurs des transistors. Le circuit inclut un trajet de shunt réalisé par une résistance dans un mode de réalisation. Ce trajet de shunt permet de minimiser le bruit par absorption d'une partie de celui-ci dans la résistance.

Le brevet US 6,026,286 décrit un circuit d'entrée pour un récepteur. Le circuit comprend des transformateurs à microbande réalisés dans une technologie monolithe à semi-conducteurs. Une boude de rétroaction à base de réactances et des éléments de couplage sont utilisés. Ceux-ci remplacent des résistances afin de diminuer le facteur de bruit du circuit par la réduction du bruit thermique du type résistive.

L'article intitulé « The Analysis of Silicon Bipolar Scaling Scheme for Low Noise and Low Power Analog Application », par N. Itoh et al. (XP010224823), décrit un schéma pour réduire la taille des transistors bipolaires analogiques. Selon l'article, il est possible de réduire la consommation de puissance en préservant des bonnes valeurs pour le facteur de bruit et le gain de puissance. Ced ce fait par une combinaison de la réduction de la taille dans la direction horizontale et celle dans la direction verticale et en appliquant des méthodes appropriées pour réduire les résistances parasites et les capacités parasites.

L'article intitulé « Minimizing Noise in Analog Bipolar Circuit Design » par D. Bowers (XP010089296) décrit des techniques de design à faible bruit. L'article considère une paire de transistors différentielle ayant un circuit de charge résistive. Selon l'article, le circuit de charge résistive a peu d'effet sur la performance de bruit.

L'invention prend en considération que les circuits de l'état de la technique présentent un fort bruit proportionnel à l'inverse de la fréquence présent dans le signal de sortie, noté dans la suite, bruit en 1/f, gênant lorsque la fréquence du signal de sortie est faible. Cela est particulièrement dommageable lorsque l'amplification du signal est principalement réalisée après le mélange, lorsque le signal est directement converti en bande de base par un unique circuit de mélange... Des problèmes peuvent aussi être observés dans des systèmes utilisant une bande étroite de modulation.

Un but de l'invention est ainsi de minimiser sélectivement le bruit en 1/f. En effet, un circuit selon l'invention comprend des caractéristiques définies dans la revendication 1.

En pratique, la présente invention concerne tout mélangeur de signaux dans lequel des résistances de charge sont nécessaires. En particulier tous mélangeurs utilisant des transistors sont concernés. En effet, de tels mélangeurs nécessitent des résistances de charge pour mettre les transistors en zone de fonctionnement et réaliser une conversion courant-tension en sortie du mélangeur. En particulier les mélangeurs présentant une structure différentielle seront visés par l'invention : cellule de Gilbert... Les mélangeurs sont utilisés dans les appareils de traitement de signaux dans lesquels des translations de fréquence sont réalisées : téléphone sans fil, téléphone de type DECT, téléphone mobile, récepteur satellite... L'invention concerne ainsi également de tels appareils de traitement du signal, le traitement du signal pouvant être réalisé à la réception, à l'émission ou à tout moment où cela est nécessaire.

L'invention sera décrite ci-après plus en détail par référence aux figures annexées parmi lesquelles :

la figure 1 est un schéma d'un circuit de mélange selon l'état de la technique dans lequel l'invention peut avantageusement être mise en oeuvre,
la figure 2 est un schéma d'un circuit de mélange particulier présentant une structure différentielle au sein duquel l'invention s'avère très avantageuse,
la figure 3 illustre l'effet de l'invention sur le bruit en 1/f,
la figure 4 est un schéma d'un récepteur à fréquence intermédiaire,
la figure 5 illustre le fonctionnement d'un récepteur à zéro fréquence intermédiaire.

Parfois les mélangeurs ayant de faibles performances en bruit en basse fréquence dégradent la sensibilité du système en ajoutant du bruit dans le signal. Ce bruit est essentiellement du bruit en 1/f. Ce bruit existe dans tous les composants actifs et dans certains composants passifs. Les origines de ces bruits sont variées mais principalement, ils sont causés par des pièges associés aux contaminations et aux défauts de cristaux. En général, ces bruits ne sont pas considérés dans les structures classiques de mélangeurs. Ils sont considérés comme inhérents à la structure même qui comporte en effet des composants actifs pour lesquels un tel bruit est inévitable. L'invention repose sur la découverte que les contributeurs majeurs peuvent être les éléments utilisés en charge et en particulier les résistances couramment utilisées pour la charge des transistors. En effet, selon l'invention, des moyens d'optimisation du bruit prennent en compte la contribution de la ou, le cas échéant, des éléments de charge dans le bruit en 1/f.

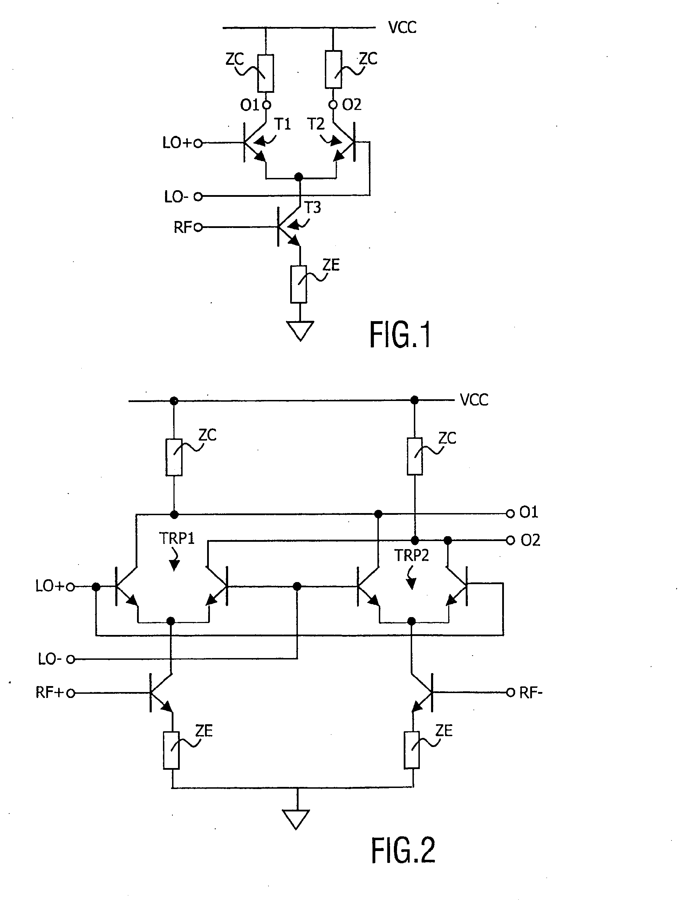

Les figures 1 et 2 sont des schémas de circuits de mélange utilisés de manière commune. La figure 1 représente un circuit simple qui présente l'inconvénient de présenter en sortie (O1, O2) une grande partie du signal LO. La figure 2 possède une structure différentielle qui permet de palier aux inconvénients de la première structure, l'influence du signal LO étant supprimée du fait même de la structure différentielle du circuit. Le circuit de mélange de la figure 2 est bien connu sous le nom de cellule de Gilbert. L'invention est avantageusement mise en oeuvre dans chacun de ces deux montages selon un mode de réalisation avantageux où les moyens d'optimisation du bruit incluent des moyens pour diminuer le bruit en 1/f au sein même de la ou, le cas échéant, des éléments de charge. Nous allons maintenant décrire ces montages.

Le circuit de mélange de la figure 1 inclut un transistor T3 réalisant une conversion d'un signal de puissance RF en courant et deux transistors T1 et T2 réalisant le mélange du courant fourni par le transistor T3 et les signaux LO+ et LO- fournis de manière différentielle à chacun des transistors T1 et T2. Classiquement, les deux transistors sont mis en charge par deux impédances ZC non optimisées pour le bruit en 1/f. Lesdites impédances sont reliées à une tension fixe VCC permettant la charge des transistors. Dans le cas où le circuit de la figure 1 est amené à fonctionner pour des basses fréquences en sortie, le signal peut être sensible au bruit en 1/f en sortie ce qui affaiblit les performances du circuit de mélange. D'autre part, ce circuit ne fonctionne pas bien à haute puissance, la polarisation des transistors ne permettant pas de rester dans un domaine linéaire de fonctionnement du mélangeur. Conformément aux usages dans le domaine des mélangeurs, l'impédance ZE peut être une simple résistance ou une inductance pour réaliser une dégénération inductive du transistor T3.

Le circuit de mélange de la figure 2 inclut deux cellules telles que décrites dans la figure 1 en parallèle. Cette structure différentielle résout le problème du circuit de la figure 1 à haute puissance. Il permet en effet de récupérer le signal d'un côté ou de l'autre du circuit même lorsqu'une haute puissance nuit au fonctionnement d'un des côtés du circuit. Dans cette structure différentielle, le signal de puissance est fourni au circuit de mélange par deux entrées sous la forme de deux signaux complémentaires RF+ et RF-. Ces signaux sont mélangés à l'aide de deux paires de transistors TRP1 et TRP2 au signal LO+ et LO-. Les paires de transistors TRP1 et TRP2 sont mises en charge par l'intermédiaire de deux éléments de charge ZC et d'une tension VCC. Dans le cas où le circuit de la figure 2 est amené à fonctionner pour des basses fréquences en sortie, le signal peut être sensible au bruit en 1/f en sortie ce qui affaiblit les performances du circuit de mélange. Il est connu que les transistors génèrent du bruit en 1/f. L'invention ne concerne pas ce bruit inévitable mais le bruit en 1/f généré par les éléments de charge et la découverte que la part de ces éléments de charge dans ce bruit est considérable.

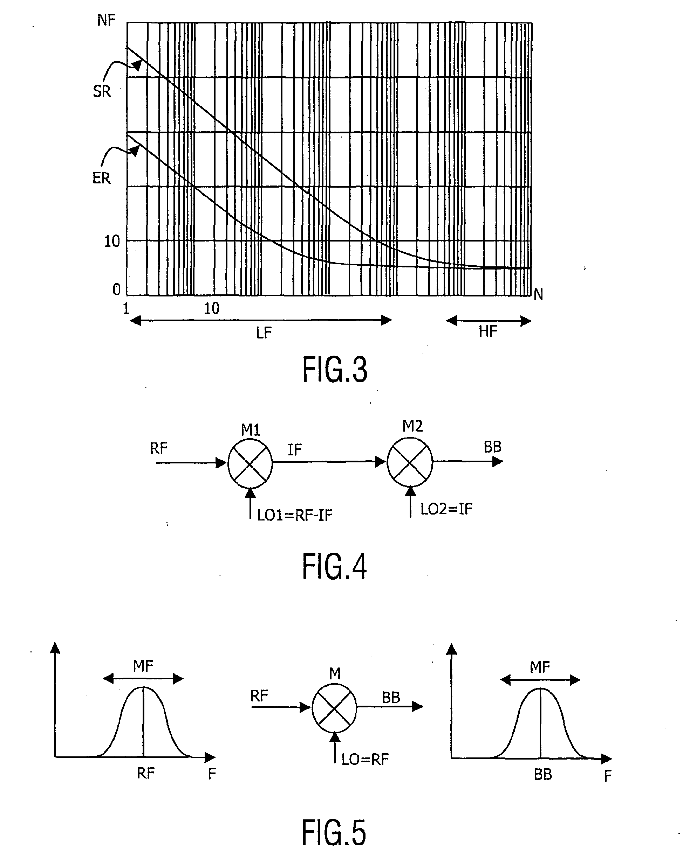

La figure 3 illustre l'effet de l'invention sur le bruit en 1/f. Les courbes présentées portent le facteur de bruit NF en dB en fonction de la fréquence de sortie N du mélangeur. La courbe SR correspond à une mise en charge effectuée à l'aide d'éléments de charge standard. Ces éléments de charge sont alors choisis en fonction des critères traditionnels de taille et nature des éléments de charge. En général, les règles de choix de taille des composants sont les suivantes. Pour les transistors, la taille est choisie pour permettre la meilleure transition de fréquence en accord avec la fréquence du signal d'entrée. Pour les résistances, la taille est déterminée pour avoir le meilleur appairage entre elles. L'allure du bruit sur la courbe SR présente deux zones distinctes principales : une zone de minimum de bruit HF résultant du bruit thermique pour les hautes fréquences et une région de bruit LF en 1/f qui croit quand la fréquence diminue et qui est du bruit de diffusion ou de recombinaison. Le bruit en 1/f est bien plus important dans le cas de la courbe SR. Ce bruit provient des transistors et, selon une proportion non négligeable que l'invention s'attache à utiliser, des caractéristiques des éléments de charge. La seconde courbe ER est obtenue pour un circuit selon un second mode de réalisation préféré décrit dans la suite dans la description des différents modes de réalisation de l'invention. On note que l'influence de l'invention sur le bruit en 1/f est considérable. L'invention est basée sur la découverte de l'influence des éléments de charge sur ces courbes. Cette influence est notamment due à la structure granulaire des résistances classiques en poly-silicium, métal...

Dans un premier mode de réalisation préféré, les éléments de charge sont choisis parmi les éléments du groupe constitué par les inductances et les résistances en silicium. Cette solution est à prendre en considération lorsqu'il est possible d'implémenter une inductance ou une résistance en silicium au sein du circuit. Cependant, l'implémentation d'une inductance n'est pas toujours possible et une résistance en silicium présente l'inconvénient d'augmenter le couplage du mélangeur avec le substrat.

Dans un second mode de réalisation préféré, au moins un élément de charge du coeur de mélange est une résistance ayant une taille calculée pour diminuer le bruit en 1/f. En effet il est possible d'améliorer le comportement de la résistance de charge vis-à-vis du bruit en 1/f en agrandissant la taille de la (ou des) résistance(s) de charge. Cette solution possède la plupart du temps l'avantage de prendre moins de place qu'une inductance. En effet lorsque la sortie du mélangeur est de basse fréquence, l'inductance prend plus de place qu'une résistance agrandie selon la technique décrite ci-après. Selon l'invention, la taille d'une résistance de charge est choisie suivant un nouveau critère de design. Ce critère consiste à choisir une taille qui permette une contribution au bruit en 1/f négligeable par rapport à celle des transistors. Le comportement d'une résistance donne un courant de bruit équivalent $i_n$ :

$$i_n{}^2 = \frac{\dfrac{K_F}{W \times L} \times I^{AF}}{f} + \frac{4kT}{R}\,,\,$$

AF étant un exposant pouvant, par exemple être égal à 2.

W et L sont respectivement largeur et longueur de la résistance. La première composante représente le bruit en 1/f et la seconde le bruit thermique. On voit ici que pour diminuer le bruit en 1/f il faut augmenter les dimensions W et L. De manière à choisir un compromis entre une taille trop grande pour les exigences des circuits semi-conducteurs et le bruit en 1/f, une comparaison est avantageusement réalisée avec le bruit en 1/f généré par les paires de transistors du coeur de mélange qui s'exprime :

$$i_n{}^2 = K_{ox} \times \frac{I_B{}^2}{f} + K_{i1} \times \frac{I_B}{f}\,.$$

Cette formule représente le courant de bruit équivalent à l'entrée du transistor. En appliquant la fonction de transfert entre l'entrée du transistor et la sortie du mélangeur (fonction de transfert dépendante des caractéristiques du signal LO), une comparaison directe des deux sources de bruit peut être réalisée pour choisir la taille à donner à la résistance. Le choix est fait de manière à garder une contribution des résistances au bruit 1/f plus petite que celle des transistors. Le bruit 1/f est donc conservé faible à l'aide d'une astuce de détermination de taille de composants.

Cependant, il faut noter que le rapport longueur sur largeur de la résistance influence la valeur même de la résistance alors que la valeur de celle ci est gardée constante lorsque ce rapport est constant. En effet, la résistance d'un matériau suit la règle suivante :

R=ρ L/S avec S=exW, ρ étant la résistivité, L étant la longueur, W la largeur, e l'épaisseur. En microélectronique on dépose une couche d'épaisseur donnée pour réaliser les résistances donc ρ et e sont constants. R est alors directement proportionnel à L/W. Il peut alors être avantageux de modifier les dimensions de la résistance de manière à ce que ce rapport longueur sur largeur soit constant. Dans ce cas la valeur de la résistance ne change pas. Ainsi, le bruit thermique dépendant de la valeur de la résistance reste constant quand on modifie la taille de la résistance à rapport longueur sur largeur constant.

Le bruit en 1/f est proportionnel à I/(W.L.f). Le mélangeur devant présenter une certain gain linéaire, cela fixe la valeur de la résistance et le courant. Seules les grandeurs W et L peuvent donc être modifiées. Avantageusement, on augmente donc les deux grandeurs W et L en même temps dans la même proportion de manière à ne pas modifier R mais à diminuer le bruit 1/f. L'exemple présenté sur la figure 3 est réalisé avec les valeurs suivantes de résistances :

|   | Courbe SR : R standard | Courbe ER : R agrandie |
|---|---|---|
| R | 520 Ω | 520 Ω |
| W | 2 μm | 28 μm |
| L | 5,2 μm | 72,8 μm |

Il est intéressant de noter que de telles résistances sont aisément repérables sur un circuit intégré à cause de leur taille importante qui les rend très visibles. Le procédé pour faire de telles tailles de résistance est commun aux procédés microélectroniques classiques de formation de résistances. Cependant l'inconvénient de cette perte de place peut être compensé par un très bon fonctionnement du circuit. Le bruit en 1/f peut en effet être totalement handicapant dans certains montages et résolu aisément par cette méthode.

C'est le cas par exemple d'un circuit de mélange direct qui se différencie des circuits de mélange classiques en ce que le mélange est fait directement dans un seul mélangeur et non dans deux mélangeurs successifs tel que représenté sur la figure 4. Le mélangeur de la figure 4 est un circuit de mélange classique composé de deux étages de mélange M1 et M2 semblables par exemple à ceux décrits sur la figure 2. Ainsi la translation de fréquence est faite en deux temps : la fréquence RF est d'abord translatée de RF à IF puis de IF à la bande de base BB~0Hz. Les mélangeurs utilisent des signaux LO1=RF-IF et LO2=IF. Ce mélange en deux temps permet d'éviter au maximum les problèmes de bruit en 1/f. Le mélangeur M2 peut paraître sensible au bruit en 1/f car sa sortie est en bande de base BB. Cependant ce mélangeur a une entrée en IF, fréquence intermédiaire, et a donc besoin de moins de courant. Le bruit en 1/f est alors négligeable selon son équation en I/(W.L.f). Le circuit de mélange direct illustré sur la figure 5 translate directement avec un unique mélangeur un signal de fréquence F=RF en en signal de fréquence F=BB en utilisant un signal de fréquence LO=RF. Ici l'intensité est importante et fixée par la fréquence d'entrée. Un fort bruit en 1/f est ici observé et le signal est en général noyé dans ce bruit. L'invention s'avère très utile dans ce cas présent. Le rôle de la taille des résistances est en effet mis à jour et exploité. L'invention est très intéressante du point de vue de l'amélioration des circuits de mélange directs qui sont de plus en plus utilisés. Ces circuits présentent en effet l'avantage d'avoir un mélangeur en moins et donc une complexité moindre.

L'invention est aussi particulièrement intéressante dans le cadre de systèmes à fort budget de gain après mélange et dans les systèmes de modulation faible bande. En effet d'une part, dans le cadre de systèmes à fort budget de gain après mélange, il est nécessaire d'avoir un bon facteur de bruit en sortie du mélangeur qui est un étage préliminaire à une amplification postérieure. D'autre part, lorsque la modulation est très faible bande (10kHz par exemple), elle est très sensible au bruit en 1/f. Dans ce cas, quelle que soit l'architecture du circuit de mélange (classique ou directe), il est nécessaire d'optimiser le bruit en 1/f du ou des mélangeurs.

En pratique, la présente invention concerne tout mélangeur de signaux dans lequel des résistances de charge sont nécessaires. En particulier tous mélangeurs utilisant des transistors en microélectronique sont concernés. En effet, de tels mélangeurs nécessitent des résistances de charge pour mettre les transistors en zone de fonctionnement et réaliser une conversion courant-tension. En particulier les mélangeurs présentant une structure différentielle seront visés par l'invention : cellule de Gilbert... Les mélangeurs sont utilisés dans les appareils de traitement de signaux dans lesquels des translations de fréquence sont réalisées : téléphone sans fil, téléphone de type DECT, téléphone mobile, récepteur satellite, récepteur TV... L'invention concerne ainsi également de tels appareils de traitement du signal, le traitement du signal pouvant être réalisé à la réception, à l'émission ou à tout moment où cela est nécessaire.

Les figures présentées concernent des modes de réalisation particuliers de l'invention. Bien que cette invention ait été décrite en accord avec les modes de réalisation présentés, un homme du métier reconnaîtra immédiatement qu'il existe des variantes aux modes de réalisation présentés et que ces variantes restent dans l'esprit et sous la portée de la présente invention. Il existe de nombreuses façons de mettre en oeuvre l'invention et de nombreuses modifications peuvent être réalisées par un homme du métier sans pour autant s'exclure de la portée définis par les revendications suivantes.

**Revendications**

1. Circuit de mélange (M) pour mélanger un premier signal (RF) à un second signal (LO) afin d'obtenir un signal de sortie dans lequel un bruit proportionnel à l'inverse de la fréquence est présent, le circuit de mélange incluant :

   - un étage de conversion (T3) pour convertir le premier signal en un courant,
   - un étage de mélange (T1, T2) pour mélanger ledit courant au second signal,
   - un circuit de charge résistive en silicium (ZC) qui met en charge ledit étage de mélange afin de fournir un signal de sortie (BB), **caractérisé en ce que** le circuit de charge résistive en silicium a une taille suffisamment large pour que la contribution du circuit de charge résistive en silicium au bruit proportionnel à l'inverse de la fréquence soit inférieur à celle des transistors du circuit de mélange.

2. Circuit de mélange selon la revendication 1, **caractérisé en ce que** la différence entre la fréquence du premier signal et la fréquence du second signal est nulle (LO=RF).

3. Circuit de mélange selon l'une des revendications 1 à 2, **caractérisé en ce qu'**il possède une structure différentielle.

4. Dispositif de traitement de signaux incluant un circuit de mélange tel que revendiqué dans l'une des revendications 1 à 3.

5. Système de télécommunication ou de radiocommunication incluant un dispositif de traitement de signaux tel que revendiqué dans la revendication 4.

6. Procédé de conception d'un circuit de mélange (M) pour mélanger un premier signal (RF) à un second signal (LO) afin d'obtenir un signal de sortie dans lequel un bruit proportionnel à l'inverse de la fréquence est présent, le circuit de mélange incluant :

   - un étage de conversion (T3) pour convertir le premier signal en un courant,
   - un étage de mélange (T1, T2) pour mélanger ledit courant au second signal,
   - un circuit de charge résistive en silicium (ZC) qui met en charge ledit étage de mélange afin de fournir un signal de sortie (BB), le circuit de charge résistive en silicium ayant une longueur et une largeur,

**caractérisé en ce que** le procédé comprend :

- une étape de dimensionnement dans laquelle la longueur et la largeur du circuit de charge résistive en silicium (ZC) sont augmentées dans la même proportion jusqu'à ce que la contribution du circuit de charge résistive en silicium au bruit proportionnel à l'inverse de la fréquence soit inférieur à celle des transistors.

**Claims**

1. Mixing circuit (M) for mixing a first signal (RF) with a second signal (LO) in order to obtain an output signal in which a noise proportional to the inverse of the frequency is present, the mixing circuit including:

   - a conversion stage (T3) for converting the first signal into a current,
   - a mixing stage (T1, T2) for mixing said current with the second signal,
   - a silicon resistive load circuit (ZC) that loads said mixing stage in order to supply an output signal (BB), **characterized in that** the silicon resistive load circuit has a sufficiently large size for the contribution of the silicon resistive load circuit to the noise proportional to the inverse of the frequency to be less than that of the transistors of the mixing circuit.

2. Mixing circuit according to Claim 1, **characterized in that** the difference between the frequency of the first signal and the frequency of the second signal is zero (LO=RF).

3. Mixing circuit according to either of Claims 1 or 2, **characterized in that** it has a differential structure.

4. Signal processing device including a mixing circuit as claimed in one of Claims 1 to 3.

5. Telecommunication or radio communication system including a signal processing device as claimed in Claim 4.

6. Method of designing a mixing circuit (M) for mixing a first signal (RF) with a second signal (LO) in order to obtain an output signal in which a noise proportional to the inverse of the frequency is present, the mixing circuit including:

   - a conversion stage (T3) for converting the first signal into a current,
   - a mixing stage (T1, T2) for mixing said current with the second signal,
   - a silicon resistive load circuit (ZC) that loads said mixing stage in order to supply an output signal (BB), the silicon resistive load circuit having a length and a width,

   **characterized in that** the method comprises:

   - a dimensioning step in which the length and the width of the silicon resistive load circuit (ZC) are augmented in the same proportion until the contribution of the silicon resistive load circuit to the noise proportional to the inverse of the frequency is less than that of the transistors.

**Patentansprüche**

1. Mischerschaltung (M) zum Mischen eines ersten Signals (RF) mit einem zweiten Signal (LO), um ein Ausgangssignal zu erhalten, in dem ein Rauschen, das zum Kehrwert der Frequenz proportional ist, vorhanden ist, wobei die Mischerschaltung enthält:

   - eine Umsetzungsstufe (T3), um das erste Signal in einen Strom umzusetzen,
   - eine Mischstufe (T1, T2), um den Strom mit dem zweiten Signal zu mischen,
   - eine resistive Ladeschaltung (ZC) aus Silicium, die die Mischstufe lädt, um ein Ausgangssignal (BB) zu liefern, **dadurch gekennzeichnet, dass** die resistive Ladeschaltung aus Silicium eine Größe hat, die ausreichend groß ist, damit der Beitrag der resistiven Ladeschaltung aus Silicium zu dem zum Kehrwert der Frequenz proportionalen Rauschen kleiner ist als jener der Transistoren der Mischerschaltung.

**2.** Mischerschaltung nach Anspruch 1, **dadurch gekennzeichnet, dass** die Differenz zwischen der Frequenz des ersten Signals und der Frequenz des zweiten Signals null ist (LO = RF).

**3.** Mischerschaltung nach einem der Ansprüche 1 bis 2, **dadurch gekennzeichnet, dass** sie eine differentielle Struktur besitzt.

**4.** Signalverarbeitungsvorrichtung, die eine Mischerschaltung nach einem der Ansprüche 1 bis 3 enthält.

**5.** Telekommunikations- oder Funkkommunikationssystem, das eine Signalverarbeitungsschaltung nach Anspruch 4 enthält.

**6.** Verfahren zum Entwerfen einer Mischerschaltung (M) zum Mischen eines ersten Signals (RF) mit einem zweiten Signal (LO), um ein Ausgangssignal zu erhalten, in dem ein zum Kehrwert der Frequenz proportionales Rauschen vorhanden ist, wobei die Mischerschaltung enthält:

- eine Umsetzungsstufe (T3), um das erste Signal in einen Strom umzusetzen,
- eine Mischstufe (T1, T2), um den Strom mit dem zweiten Signal zu mischen,
- eine resistive Ladeschaltung (ZC) aus Silicium, die die Mischstufe lädt, um ein Ausgangssignal (BB) zu liefern, wobei die resistive Ladeschaltung aus Silicium eine Länge und eine Breite besitzt,

**dadurch gekennzeichnet, dass** das Verfahren enthält:

- einen Dimensionierungsschritt, in dem die Länge und die Breite der resistiven Ladeschaltung (ZC) aus Silicium im gleichen Verhältnis vergrößert werden, bis der Beitrag der resistiven Ladeschaltung aus Silicium zu dem zum Kehrwert der Frequenz proportionalen Rauschen kleiner ist als jener der Transistoren.

FIG.1

FIG.2

FIG.3

FIG.4

FIG.5

**EP 1 298 792 B1**

## RÉFÉRENCES CITÉES DANS LA DESCRIPTION

### Documents brevets cités dans la description

- EP 0232560 A
- US 6026286 A